# EUROPEAN PATENT APPLICATION

(11) **EP 4 730 928 A1**
(43) Date of publication of application: **22.04.2026**
(21) Application number: 23941524.3
(22) Date of filing: 13.06.2023
(51) Int. Cl.: H05K 3/46

(54) **CIRCUIT FORMING METHOD AND CIRCUIT FORMING APPARATUS**

(71) Applicant: Fuji Corporation, Chiryu-shi, Aichi 472-8686 (JP)
(72) Inventor: TOMINAGA, Ryojiro, Chiryu-shi, Aichi 472-8686 (JP)
(74) Representative: Grünecker Patent- und Rechtsanwälte PartG mbB
(86) International application number: PCT/JP2023/021909
(87) International publication number: WO 2024/257216

(57) **Abstract**

According to the present disclosure, there is provided a circuit forming method including: a first component placing step of placing, on wiring, a first component including a conductive portion configured to conduct between an upper surface and a lower surface such that the conductive portion at the lower surface of the first component is electrically connected to the wiring; a resin layer forming step of forming, on the first component and the wiring, a resin layer including an opening through which the conductive portion at the upper surface of the first component is exposed; and a second component placing step of placing, on the first component, a second component including a conductive portion at least at a lower surface such that the conductive portion at the lower surface of the second component is electrically connected to the conductive portion at the upper surface of the first component exposed through the opening.

## Description

### Technical Field

The present invention relates to a circuit forming method of a circuit board in which multiple components are stacked and to a circuit forming apparatus.

### Background Art

Patent Literature 1 described below discloses a technique for forming a circuit board in which multiple components are stacked.

### Citation List

### Patent Literature

Patent Literature 1: JP-A-2007-329452

### Summary of the Invention

### Technical Problem

An object is to appropriately form a circuit board in which multiple components are stacked.

### Solution to Problem

In order to achieve the above object, the present description discloses a circuit forming method including: a first component placing step of placing, on wiring, a first component including a conductive portion configured to conduct between an upper surface and a lower surface such that the conductive portion at the lower surface of the first component is electrically connected to the wiring; a resin layer forming step of forming, on the first component and the wiring, a resin layer including an opening through which the conductive portion at the upper surface of the first component is exposed; and a second component placing step of placing, on the first component, a second component including a conductive portion at least at a lower surface such that the conductive portion at the lower surface of the second component is electrically connected to the conductive portion at the upper surface of the first component exposed through the opening.

In addition, the present description discloses a circuit forming apparatus including: a placing device configured to place a component at a certain position; a resin layer forming device configured to form a resin layer using a curable resin; and a control device, in which the control device is configured to execute: a first component placing process of placing, by the placing device, on wiring, a first component including a conductive portion configured to conduct between an upper surface and a lower surface such that the conductive portion at the lower surface of the first component is electrically connected to the wiring; a resin layer forming process of forming, by the resin layer forming device, on the first component and the wiring, a resin layer including an opening through which the conductive portion at the upper surface of the first component is exposed; and a second component placing process of placing, by the placing device, on the first component, a second component including a conductive portion at least at a lower surface such that the conductive portion at the lower surface of the second component is electrically connected to the conductive portion at the upper surface of the first component exposed through the opening.

### Advantageous Effects of Invention

In the present disclosure, the first component including the conductive portion that conducts between the upper surface and the lower surface is placed on the wiring such that the conductive portion at the lower surface of the first component is electrically connected to the wiring. Next, the resin layer including the opening through which the conductive portion at the upper surface of the first component is exposed is formed on the first component and the wiring. Then, the second component including the conductive portion at least at the lower surface is placed on the first component such that the conductive portion at the lower surface of the second component is electrically connected to the conductive portion at the upper surface of the first component exposed through the opening. As a result, a circuit board in which multiple components are stacked can be appropriately formed.

### Brief Description of Drawings

Fig. 1 is a diagram showing an example of a circuit forming apparatus.
Fig. 2 is a block diagram showing an example of a control device.
Fig. 3 is a cross-sectional view showing an example of a circuit board in a state in which a resin layered body is formed.
Fig. 4 is a cross-sectional view showing an example of a circuit board in a state in which wiring is formed on the resin layered body.
Fig. 5 is a cross-sectional view showing an example of a circuit board in a state in which a resin layered body is further formed on the resin layered body.
Fig. 6 is a cross-sectional view showing an example of a circuit board in a state in which wiring connected to the wiring is formed.
Fig. 7 is a cross-sectional view showing an example of a circuit board in a state in which a resin layered body is formed such that an end portion of the wiring is exposed.
Fig. 8 is a cross-sectional view showing an example of a circuit board in a state in which conductive paste is applied onto the wiring.
Fig. 9 is a cross-sectional view showing an example of a circuit board in a state in which a thermosetting resin is applied onto the resin layered body.
Fig. 10 is a cross-sectional view showing an example of a circuit board in a state in which a first-layer electronic component is mounted.
Fig. 11 is a cross-sectional view showing an example of a circuit board in a state in which the electronic component is pressed against the resin layered body.
Fig. 12 is a cross-sectional view showing an example of a circuit board in a state in which a thermosetting resin is applied around the electronic component.
Fig. 13 is a cross-sectional view showing an example of a circuit board in a state in which wiring connected to the wiring is formed.
Fig. 14 is a cross-sectional view showing an example of a circuit board in a state in which a resin layered body is formed so as to cover the electronic component.
Fig. 15 is a cross-sectional view showing an example of a circuit board in a state in which wiring connected to the wiring is formed.
Fig. 16 is a cross-sectional view showing an example of a circuit board in a state in which a resin layered body is formed such that an end portion of the wiring is exposed.
Fig. 17 is a cross-sectional view showing an example of a circuit board in a state in which a second-layer electronic component is mounted.
Fig. 18 is a cross-sectional view showing an example of a circuit board in a state in which wiring is formed on the resin layered body.
Fig. 19 is a cross-sectional view showing an example of a circuit board in a state in which a resin layered body is further formed on the resin layered body.
Fig. 20 is a cross-sectional view showing an example of a circuit board in a state in which a first-layer electronic component is mounted.
Fig. 21 is a cross-sectional view showing an example of a circuit board in a state in which a resin layered body is formed so as to cover the electronic component.
Fig. 22 is a cross-sectional view showing an example of a circuit board in a state in which wiring that is connected to an electrode at an upper surface of the electronic component is formed.
Fig. 23 is a cross-sectional view showing an example of a circuit board in a state in which a resin layered body is further formed on the resin layered body.
Fig. 24 is a cross-sectional view showing an example of a circuit board in a state in which a second-layer electronic component is mounted.
Fig. 25 is a cross-sectional view showing an example of a circuit board in a state in which wiring is formed on a resin layered body covering the electronic component.
Fig. 26 is a cross-sectional view showing an example of a circuit board in a state in which a resin layered body is further formed on the resin layered body.
Fig. 27 is a cross-sectional view showing an example of a circuit board in a state in which bumps are formed on the wiring and inside an opening.
Fig. 28 is a cross-sectional view showing an example of a circuit board in a state in which a second-layer electronic component is mounted.

### Description of Embodiments

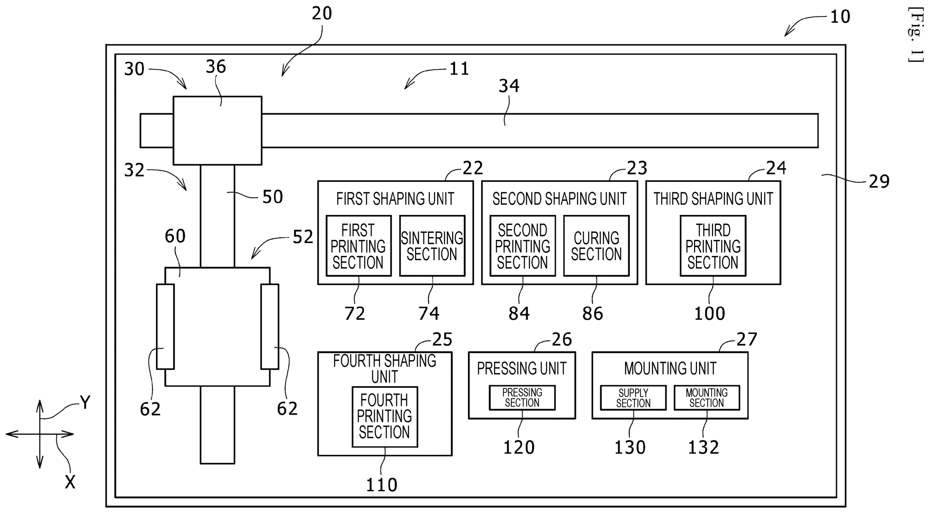

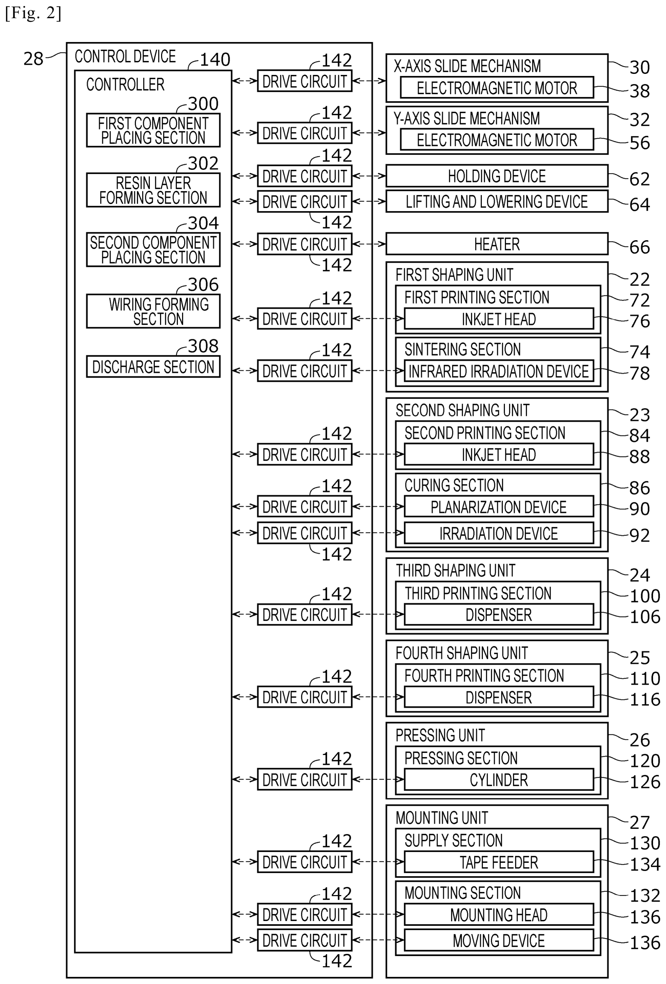

Fig. 1 shows an example of circuit forming apparatus 10. Circuit forming apparatus 10 includes conveyance device 20, first shaping unit 22, second shaping unit 23, third shaping unit 24, fourth shaping unit 25, pressing unit 26, mounting unit 27, and control device (refer to Fig. 2) 28. Conveyance device 20, first shaping unit 22, second shaping unit 23, third shaping unit 24, fourth shaping unit 25, pressing unit 26, and mounting unit 27 are disposed on base 29 of circuit forming apparatus 10. Base 29 generally has a rectangular shape, and, in the following description, a longitudinal direction of base 29 is referred to as an X-axis direction, a lateral direction of base 29 is referred to as a Y-axis direction, and a direction orthogonal to both the X-axis direction and the Y-axis direction is referred to as a Z-axis direction.

Conveyance device 20 includes X-axis slide mechanism 30 and Y-axis slide mechanism 32. X-axis slide mechanism 30 includes X-axis slide rail 34 and X-axis slider 36. X-axis slide rail 34 is disposed on base 29 so as to extend in the X-axis direction. X-axis slider 36 is held by X-axis slide rail 34 so as to be slidable in the X-axis direction. Additionally, X-axis slide mechanism 30 includes electromagnetic motor (refer to Fig. 2) 38, and X-axis slider 36 moves to any position in the X-axis direction by driving of electromagnetic motor 38. In addition, Y-axis slide mechanism 32 includes Y-axis slide rail 50 and stage 52. Y-axis slide rail 50 is disposed on base 29 so as to extend in the Y-axis direction and is movable in the X-axis direction. One end portion of Y-axis slide rail 50 is coupled to X-axis slider 36. Stage 52 is held on Y-axis slide rail 50 so as to be slidable in the Y-axis direction. Further, Y-axis slide mechanism 32 includes electromagnetic motor (refer to Fig. 2) 56, and stage 52 moves to any position in the Y-axis direction by driving of electromagnetic motor 56. As a result, stage 52 moves to any position on base 29 by driving of X-axis slide mechanism 30 and Y-axis slide mechanism 32.

Stage 52 includes pedestal 60, holding device 62, lifting and lowering device (refer to Fig. 2) 64, and heater (refer to Fig. 2) 66. Pedestal 60 is formed in a flat plate shape, and a board is placed on an upper surface thereof. Holding device 62 is provided on both side portions of pedestal 60 in the X-axis direction. Both edge portions in the X-axis direction of the board placed on pedestal 60 are clamped by holding devices 62, whereby the board is held in a fixed manner. Additionally, lifting and lowering device 64 is disposed below pedestal 60 and lifts and lowers pedestal 60. Further, heater 66 is incorporated in pedestal 60 and heats the board placed on pedestal 60 to any temperature.

First shaping unit 22 is a unit that shapes wiring of a circuit board, and includes first printing section 72 and sintering section 74. First printing section 72 includes inkjet head (refer to Fig. 2) 76, and inkjet head 76 linearly discharges metal ink. The metal ink contains metal fine particles of a nanometer size, for example, silver fine particles, dispersed in a solvent. Surfaces of the metal fine particles are coated with a dispersant, whereby aggregation in the solvent is prevented. Further, inkjet head 76 discharges metal ink from multiple nozzles by, for example, a piezo method using a piezoelectric element.

Sintering section 74 includes infrared irradiation device (refer to Fig. 2) 78. Infrared irradiation device 78 is a device that irradiates the discharged metal ink with infrared rays. The metal ink irradiated with infrared rays is sintered, whereby wiring is formed. Sintering of the metal ink is a phenomenon in which, by applying energy, vaporization of a solvent, decomposition of a protective film of the metal fine particles, that is, a dispersant, and the like are performed, and the metal fine particles come into contact with or are fused to each other, whereby the conductivity increases. The metal ink is sintered, whereby metal wiring is formed.

Additionally, second shaping unit 23 is a unit that shapes a resin layer of the circuit board, and includes second printing section 84 and curing section 86. Second printing section 84 includes inkjet head (refer to Fig. 2) 88, and inkjet head 88 discharges an ultraviolet curable resin. The ultraviolet curable resin is a resin that is cured by irradiation with ultraviolet rays. Inkjet head 88 may employ, for example, a piezo method using a piezoelectric element or a thermal method in which a resin is heated to generate bubbles and discharged from multiple nozzles.

Curing section 86 includes planarization device (refer to Fig. 2) 90 and irradiation device (refer to Fig. 2) 92. Planarization device 90 planarizes an upper surface of the ultraviolet curable resin discharged by inkjet head 88 and makes, for example, a thickness of the ultraviolet curable resin uniform by scraping off an excess resin with a roller or a blade while leveling a surface of the ultraviolet curable resin. In addition, irradiation device 92 includes a mercury lamp or an LED as a light source, and irradiates the discharged ultraviolet curable resin with ultraviolet rays. As a result, the discharged ultraviolet curable resin is cured, whereby a resin layer is formed.

Third shaping unit 24 is a unit that shapes a connection portion between an electrode of an electronic component and wiring, on the circuit board, and includes third printing section 100. Third printing section 100 includes dispenser (refer to Fig. 2) 106, and dispenser 106 discharges conductive paste. The conductive paste contains metal particles of a micrometer size dispersed in a resin that is cured by heating at a relatively low temperature. Meanwhile, the metal particles are in the form of flakes, and viscosity of the conductive paste is relatively higher as compared to that of the metal ink.

The conductive paste discharged by dispenser 106 is heated by heater 66 incorporated in pedestal 60. In the heated conductive paste, the resin is cured. At this time, in the conductive paste, the resin is cured and shrinks, and flake-shaped metal particles dispersed in the resin come into contact with each other. As a result, the conductive paste exhibits conductive properties. Further, the resin of the conductive paste is an organic adhesive, and exhibits an adhesive force when cured by heating.

Fourth shaping unit 25 is a unit that shapes a resin for fixing the electronic component to the circuit board, and includes fourth printing section 110. Fourth printing section 110 includes dispenser (refer to Fig. 2) 116, and dispenser 116 discharges a thermosetting resin. The thermosetting resin is a resin that is cured by heating. Dispenser 116 employs, for example, an air pulse method using compressed air. The thermosetting resin discharged by dispenser 116 is heated and cured by heater 66 incorporated in pedestal 60.

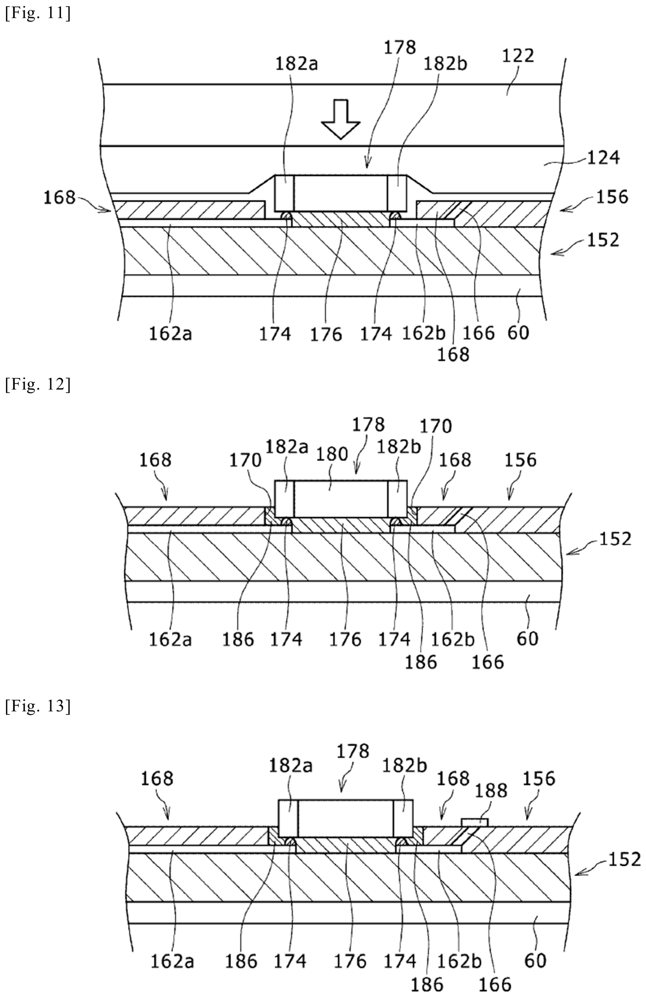

Additionally, pressing unit 26 is a unit for pressing the circuit board, and includes pressing section 120. Pressing section 120 includes pressing plate (refer to Fig. 11) 122, rubber plate (refer to Fig. 11) 124, and cylinder (refer to Fig. 2) 126. Rubber plate 124 is formed of, for example, silicone rubber and has a plate shape. Further, pressing plate 122 is formed of, for example, steel material and has a plate shape. Rubber plate 124 is affixed to a lower surface of pressing plate 122, and pressing plate 122 is pressed against the circuit board by an operation of cylinder 126. Consequently, the circuit board is pressed by pressing plate 122 via rubber plate 124. By controlling the operation of cylinder 126, a force for pressing the board can be changed to be controllable.

In addition, mounting unit 27 is a unit that mounts the electronic component on the circuit board, and includes supply section 130 and mounting section 132. Supply section 130 includes multiple tape feeders (refer to Fig. 2) 134 that feed taped electronic components one by one, and supplies the electronic component at a supply position. Supply section 130 is not limited to tape feeder 134, and may be a tray-type supply device that picks up the electronic component from a tray and that supplies the electronic component. Alternatively, supply section 130 may include both a tape type and a tray type, or other supply devices.

Mounting section 132 includes mounting head (refer to Fig. 2) 136 and moving device (refer to Fig. 2) 138. Mounting head 136 includes a suction nozzle (not shown) for picking up and holding the electronic component. The suction nozzle picks up and holds the electronic component by suction of air when a negative pressure is supplied from a positive and negative pressure supply device (not shown). Then, the electronic component is released when a slight positive pressure is supplied from the positive and negative pressure supply device. Additionally, moving device 138 moves mounting head 136 between the supply position of the electronic component by tape feeder 134 and the board placed on pedestal 60. As a result, in mounting section 132, the electronic component supplied from tape feeder 134 is held by the suction nozzle, and the electronic component held by the suction nozzle is mounted on the board.

Further, control device 28 includes controller 140 and multiple drive circuits 142, as shown in Fig. 2. Multiple drive circuits 142 are connected to electromagnetic motors 38 and 56, holding device 62, lifting and lowering device 64, heater 66, inkjet head 76, infrared irradiation device 78, inkjet head 88, planarization device 90, irradiation device 92, dispenser 106, dispenser 116, cylinder 126, tape feeder 134, mounting head 136, and moving device 138 mentioned above. Controller 140 includes CPU, ROM, RAM, and the like, and is mainly implemented by a computer and connected to multiple drive circuits 142. As a result, operations of conveyance device 20, first shaping unit 22, second shaping unit 23, third shaping unit 24, fourth shaping unit 25, pressing unit 26, and mounting unit 27 are controlled by controller 140.

In circuit forming apparatus 10, by the above-mentioned configuration, a resin layered body is formed on pedestal 60, and wiring is formed on an upper surface of the resin layered body. Subsequently, the electrode of the electronic component is electrically connected to the wiring via the conductive paste, and the electronic component is fixed by the resin. Then, multiple electronic components are stacked, whereby a circuit board is formed.

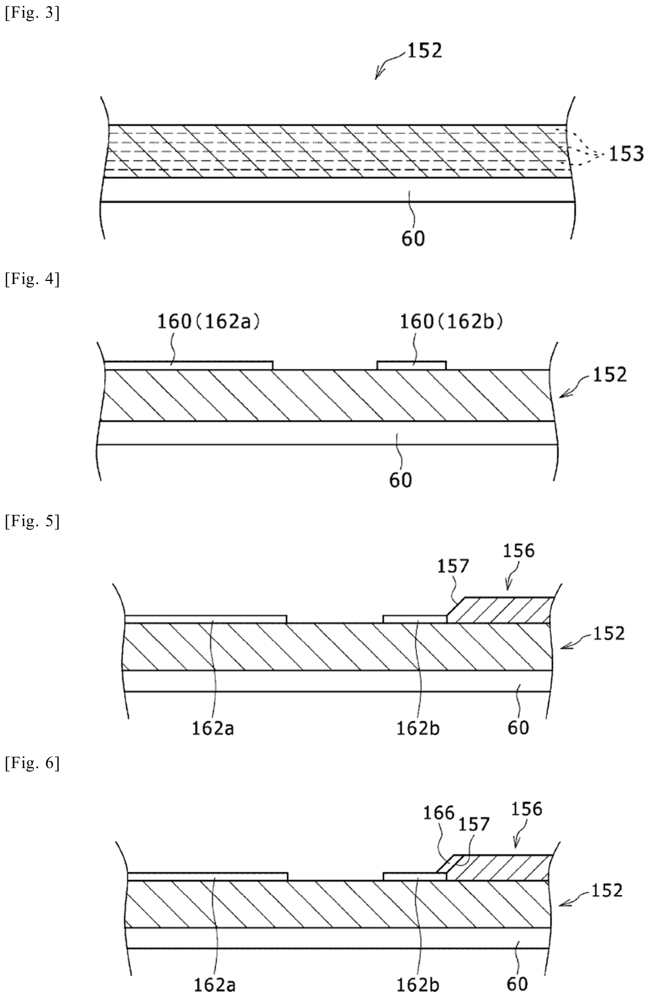

An example of a process of forming the circuit board will be described. Specifically, first, stage 52 is moved to a position below second shaping unit 23. Then, in second shaping unit 23, resin layered body 152 is formed on pedestal 60 of stage 52, as shown in Fig. 3. Resin layered body 152 is formed by repeating discharge of an ultraviolet curable resin from inkjet head 88 and irradiation with ultraviolet rays from irradiation device 92 onto the discharged ultraviolet curable resin.

In detail, in second printing section 84 of second shaping unit 23, inkjet head 88 discharges the ultraviolet curable resin as a thin film onto an upper surface of pedestal 60. Subsequently, when the ultraviolet curable resin is discharged as a thin film, in curing section 86, the ultraviolet curable resin is planarized by planarization device 90 such that a film thickness of the ultraviolet curable resin becomes uniform. Then, irradiation device 92 irradiates the thin film-shaped ultraviolet curable resin with ultraviolet rays. As a result, thin film-shaped resin layer 153 is formed on pedestal 60.

Subsequently, inkjet head 88 discharges the ultraviolet curable resin as a thin film onto thin film-shaped resin layer 153. Then, the thin film-shaped ultraviolet curable resin is planarized by planarization device 90, and irradiation device 92 irradiates the ultraviolet curable resin discharged as a thin film with ultraviolet rays, whereby thin film-shaped resin layer 153 is stacked on thin film-shaped resin layer 153. In this way, by repeating discharge of an ultraviolet curable resin onto thin film-shaped resin layer 153 and irradiation with ultraviolet rays, multiple resin layers 153 are stacked, whereby resin layered body 152 is formed.

Next, when resin layered body 152 is formed, stage 52 is moved to a position below first shaping unit 22. Then, in first printing section 72 of first shaping unit 22, inkjet head 76 linearly discharges metal ink 160 onto an upper surface of resin layered body 152 in accordance with a circuit pattern, as shown in Fig. 4. Subsequently, infrared irradiation device 78 irradiates metal ink 160 discharged in accordance with the circuit pattern with infrared rays, in sintering section 74 of first shaping unit 22. Consequently, metal ink 160 is sintered, whereby wiring 162 is formed on the upper surface of resin layered body 152. In Fig. 4, two wirings 162 are formed, and when two wirings 162 are distinguished from each other, first wiring of two wirings 162 is referred to as wiring 162a, and second wiring is referred to as wiring 162b.

Subsequently, when wirings 162 are formed on resin layered body 152, stage 52 is moved to a position below second shaping unit 23. Then, in second shaping unit 23, resin layered body 156 is formed on resin layered body 152, as shown in Fig. 5. Resin layered body 156 is formed on resin layered body 152 so as to be continuous with an end of wiring 162b opposite to an end facing wiring 162a. In addition, a portion of resin layered body 156 that is continuous with wiring 162b is formed as inclined surface 157. Resin layered body 156 is formed by repeating discharge of an ultraviolet curable resin by inkjet head 88, planarization by planarization device 90, and irradiation with ultraviolet rays by irradiation device 92, in the same manner as resin layered body 152.

Subsequently, stage 52 is moved to a position below first shaping unit 22, and in first shaping unit 22, wiring 166 is formed on inclined surface 157 of resin layered body 156 so as to come into contact with wiring 162b, as shown in Fig. 6. Wiring 166 is formed by performing discharge of metal ink by inkjet head 76 and irradiation with infrared rays by infrared irradiation device 78, in the same manner as wiring 162.

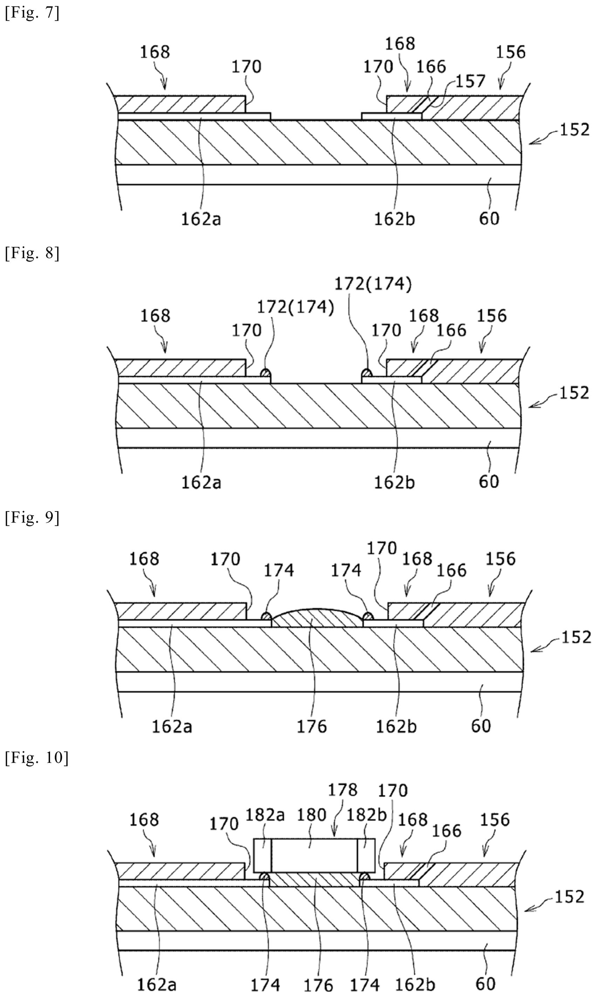

Subsequently, stage 52 is moved to a position below second shaping unit 23. Then, in second shaping unit 23, resin layered body 168 is formed on resin layered body 152, as shown in Fig. 7. Resin layered body 168 is formed on resin layered body 152 such that end portions of two wirings 162 that face each other are exposed and so as to be continuous with inclined surface 157 of resin layered body 156. Meanwhile, a step portion between resin layered body 152 and resin layered body 168 functions as cavity 170. Resin layered body 168 is formed by the same method as resin layered body 152.

Subsequently, stage 52 is moved to a position below third shaping unit 24. Then, in third printing section 100 of third shaping unit 24, dispenser 106 discharges conductive paste 172 onto the end portions of two wirings 162 that face each other, as shown in Fig. 8. In this way, when conductive paste 172 is discharged onto the end portions of wirings 162, resin layered body 152 is heated by heater 66 incorporated in pedestal 60. At this time, conductive paste 172 is heated and cured via resin layered body 152. Consequently, conductive paste 172 exhibits conductive properties. Since cured conductive paste 172 functions as a bump, cured conductive paste 172 is referred to as bump 174.

Subsequently, stage 52 is moved to a position below fourth shaping unit 25. Then, in fourth printing section 110 of fourth shaping unit 25, dispenser 116 discharges thermosetting resin 176 onto the upper surface of resin layered body 152 between the end portions of two wirings 162 that face each other, as shown in Fig. 9.

Subsequently, stage 52 is moved to a position below mounting unit 27. In mounting unit 27, electronic component (refer to Fig. 10) 178 is supplied by tape feeder 134, and electronic component 178 is held by the suction nozzle of mounting head 136. Electronic component 178 includes component body 180 and two electrodes 182 disposed on both end portions of component body 180. Electronic component 178 is a so-called chip component, and electrode 182 conducts between an upper surface and a lower surface of electronic component 178. Then, mounting head 136 is moved by moving device 138, and electronic component 178 held by the suction nozzle is mounted, as shown in Fig. 10, inside cavity 170 so as to be electrically connected to wiring 162. Specifically, electronic component 178 is mounted such that electrodes 182 at the lower surface of electronic component 178 come into contact with bumps 174 formed on wirings 162. At this time, component body 180 of electronic component 178 comes into contact with thermosetting resin 176 discharged between wirings 162. That is, conductive paste 172 is discharged onto an intended mounting position for electrode 182 on wiring 162, and thermosetting resin 176 is discharged onto an intended mounting position for component body 180. Therefore, by mounting electronic component 178, electrode 182 comes into contact with bump 174 formed on wiring 162, and component body 180 comes into contact with thermosetting resin 176. Then, thermosetting resin 176 that comes into contact with component body 180 is enclosed between component body 180 and resin layered body 152. That is, thermosetting resin 176 is encapsulated between the upper surface of resin layered body 152 and a lower surface of component body 180. Note that the electrode of two electrodes 182 that comes into contact with bump 174 formed on wiring 162a is referred to as electrode 182a, and the electrode of two electrodes 182 that comes into contact with bump 174 formed on wiring 162b is referred to as electrode 182b.

In this way, when electronic component 178 is mounted, stage 52 is moved to a position below pressing unit 26. Then, in pressing section 120 of pressing unit 26, electronic component 178 is pressed downward from above by pressing plate 122 via rubber plate 124, as shown in Fig. 11. Additionally, when electronic component 178 is pressed in pressing unit 26, resin layered body 152 is heated by heater 66 incorporated in pedestal 60. Consequently, thermosetting resin 176 is heated and cured via resin layered body 152. When electronic component 178 is pressed by pressing plate 122 in this way, component body 180 and thermosetting resin 176 come into close contact with each other, and electrode 182 and bump 174 come into close contact with each other. As a result, by a bonding force of thermosetting resin 176, electronic component 178 is fixed, at component body 180, to the upper surface of resin layered body 152, and close contact between electrode 182 and bump 174 ensures electrical connection between electronic component 178 and wiring 162.

Then, when pressing in pressing unit 26 is completed, stage 52 is moved to a position below fourth shaping unit 25. Then, in fourth printing section 110 of fourth shaping unit 25, dispenser 116 discharges thermosetting resin 186 between a side surface of electronic component 178 and cavity 170, as shown in Fig. 12. Then, resin layered body 152 is heated by heater 66 incorporated in pedestal 60. Consequently, thermosetting resin 186 is heated and cured via resin layered body 152. At this time, thermosetting resin 186 is cured while covering the side surface of electronic component 178. That is, in electronic component 178 mounted inside cavity 170, thermosetting resins 176 and 186 are encapsulated between the upper surface of resin layered body 152 and the lower surface of component body 180 and cured while covering the side surface of electronic component 178. As a result, electronic component 178 mounted inside cavity 170 is fixed by the cured resin.

Subsequently, stage 52 is moved to a position below first shaping unit 22, and in first shaping unit 22, wiring 188 is formed on resin layered bodys 156 and 168 so as to come into contact with wiring 166, as shown in Fig. 13. Wiring 188 is formed by the same method as wiring 162.

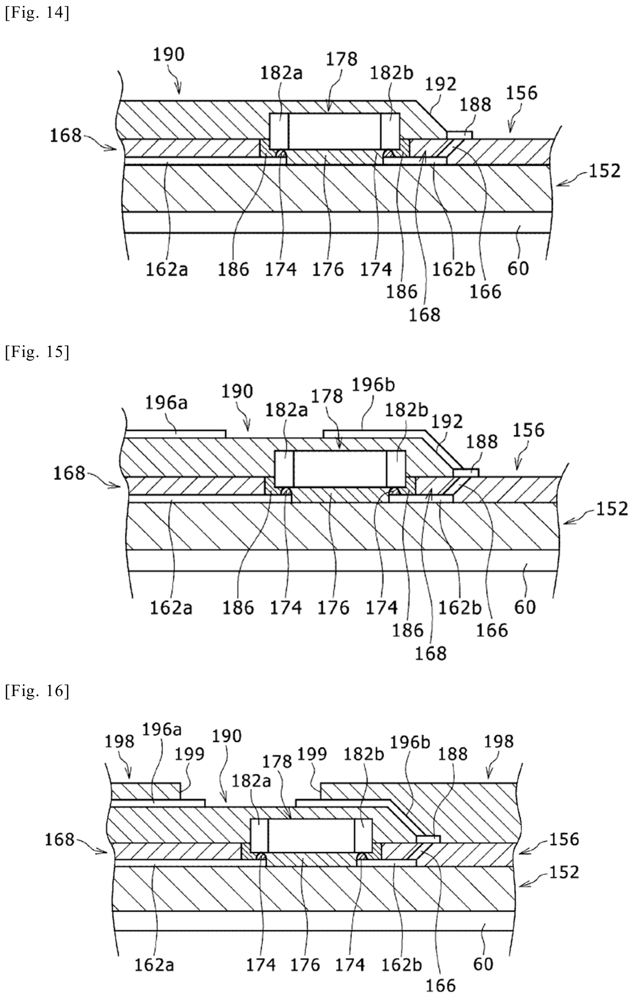

Subsequently, stage 52 is moved to a position below second shaping unit 23. Then, in second shaping unit 23, resin layered body 190 is formed on resin layered body 168 and electronic component 178, as shown in Fig. 14. Resin layered body 190 is formed on resin layered body 168 and electronic component 178 so as to be continuous with an end of wiring 188. In addition, a portion of resin layered body 190 that is continuous with wiring 188 is formed in inclined surface 192. Resin layered body 190 is formed by the same method as resin layered body 152.

Subsequently, stage 52 is moved to a position below first shaping unit 22, and two wirings 196 on resin layered body 190 are formed in first shaping unit 22, as shown in Fig. 15. When two wirings 196 are distinguished from each other, first wiring of two wirings 196 is referred to as wiring 196a, and second wiring is referred to as wiring 196b. Wiring 196b is formed to reach an upper surface of resin layered body 190 via inclined surface 192 of resin layered body 190 so as to come into contact with wiring 188. Meanwhile, wiring 196a is formed such that one end of wiring 196b faces one end of wiring 196a on the upper surface of resin layered body 190. Wiring 196 is formed by the same method as wiring 162.

Subsequently, stage 52 is moved to a position below second shaping unit 23. Then, in second shaping unit 23, resin layered body 198 is formed on resin layered bodies 156 and 190, as shown in Fig. 16. Resin layered body 198 is formed on resin layered bodies 156 and 190 such that end portions of two wirings 196 that face each other are exposed. Meanwhile, a step portion between resin layered body 198 and resin layered body 190 functions as cavity 199. It should be noted that resin layered body 198 is formed by the same method as resin layered body 152.

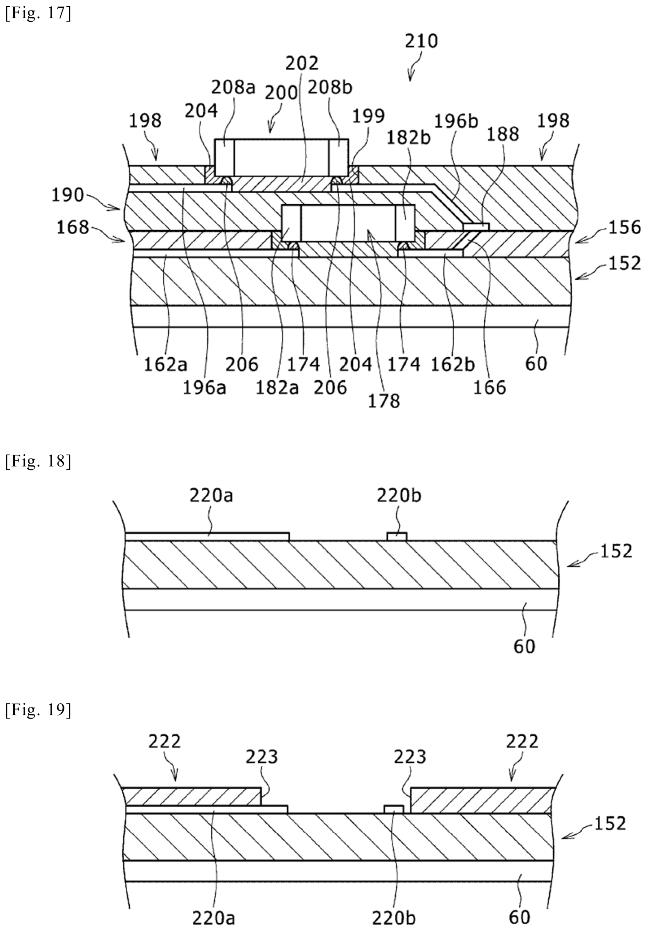

Then, as shown in Fig. 17, electronic component 200 is mounted inside cavity 199 of resin layered body 198 by the same method as electronic component 178 and fixed by thermosetting resins 202 and 204. That is, when resin layered body 198 is formed, conductive paste is discharged onto the end portions of two wirings 196 that face each other, and cured by heating of heater 66, whereby bumps 206 are formed. Next, thermosetting resin 202 is discharged between the end portions of two wirings 196 that face each other. It should be noted that electronic component 200 is a chip component, similarly to electronic component 178, and includes two electrodes 208. Therefore, electrode 208 of electronic component 200 also conducts between an upper surface and a lower surface of electronic component 200. Then, electronic component 200 is mounted inside cavity 199 such that electrodes 208 at the lower surface of electronic component 200 come into contact with bumps 206 formed on wirings 196. Next, electronic component 200 mounted inside cavity 199 is pressed downward from above by pressing plate 122 via rubber plate 124. At this time, thermosetting resin 202 is heated and cured. Then, after thermosetting resin 204 is discharged between a side surface of electronic component 200 and cavity 199, thermosetting resin 204 is heated and cured. In this way, electronic component 200 is mounted inside cavity 199 of resin layered body 198 and fixed by thermosetting resins 202 and 204. Note that the electrode of two electrodes 208 of electronic component 200 that comes into contact with bump 206 formed on wiring 196a is referred to as electrode 208a, and the electrode of two electrodes 208 that comes into contact with bump 206 formed on wiring 196b is referred to as electrode 208b.

Consequently, circuit board 210 in which two electronic components 178 and 200 are stacked is formed. In this way, by forming circuit board 210 in which multiple electronic components 178 and 200 are stacked, it is possible to form a circuit board on which many electronic components are mounted. However, in circuit board 210, wiring is led out from electrode 182 at the lower surface of electronic component 178 located in a lower layer to above electronic component 178, and the wiring is connected to electrode at the lower surface of electronic component 200 located in an upper layer, so that a wiring path becomes long. Specifically, wiring 162b is connected to electrode 182b at the lower surface of electronic component 178 via bump 174. Additionally, wirings 166, 188, and 196b are formed so as to extend above electronic component 178 by bypassing a lateral side of electronic component 178, and wiring 166 and wiring 162b are connected to each other. Wiring 196b extending above electronic component 178 is connected to electrode 208b at the lower surface of electronic component 200 via bump 206. Therefore, the wiring path connecting electrode 182b of electronic component 178 to electrode 208b of electronic component 200 is wirings 162b, 166, 188, and 196b, and becomes long. In such a long wiring path, a circuit area may become enlarged, and circuit characteristics may deteriorate because of an increase in wiring resistance.

In view of this, in circuit forming apparatus 10, wiring is led out from an electrode at an upper surface of a lower-layer electronic component, and the wiring is connected to an electrode at a lower surface of an upper-layer electronic component. Specifically, when resin layered body 152 is formed on pedestal 60, two wirings 220a and 220b are formed on the upper surface of resin layered body 152 in first shaping unit 22, as shown in Fig. 18. Wiring 220a is formed at the same position as wiring 162a of circuit board 210, and a length of wiring 220a is substantially the same as a length of wiring 162a. In addition, wiring 220b is formed at the same position as wiring 162b of circuit board 210, but a length of wiring 220b is shorter than a length of wiring 162b of circuit board 210. Wiring 220 is formed by the same method as wiring 162.

Subsequently, in second shaping unit 23, resin layered body 222 is formed on resin layered body 152, as shown in Fig. 19. Resin layered body 222 is formed on resin layered body 152 such that an entirety of wiring 220b is exposed and an end portion of wiring 220a that faces an end portion of wiring 220b is exposed. Meanwhile, a step portion between resin layered body 152 and resin layered body 222 functions as cavity 223. Resin layered body 222 is formed by the same method as resin layered body 152.

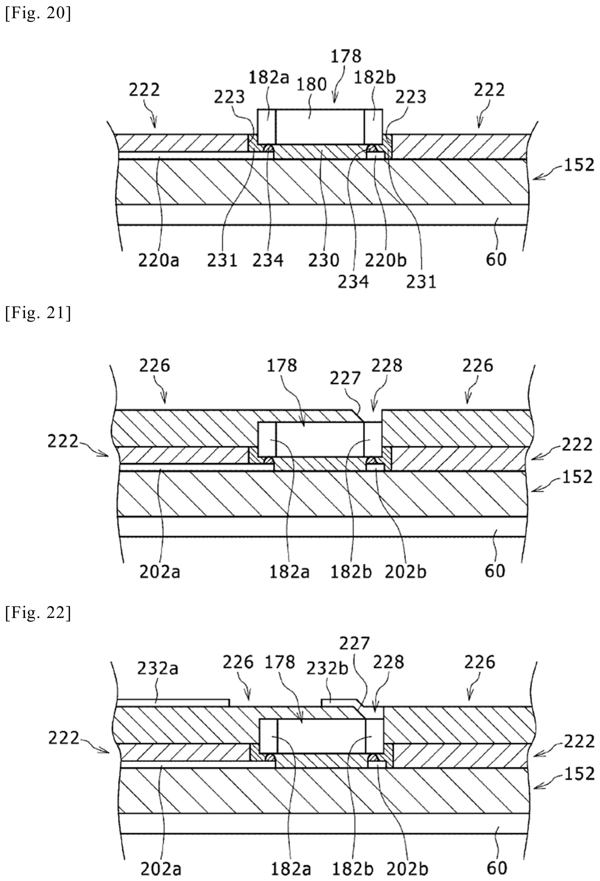

Next, as shown in Fig. 20, electronic component 178 is mounted inside cavity 223 of resin layered body 222 and fixed by thermosetting resins 230 and 231. That is, when resin layered body 222 is formed, conductive paste is discharged onto the end portions of two wirings 220 that face each other, and cured by heating of heater 66, whereby bumps 234 are formed. Next, thermosetting resin 230 is discharged between the end portions of two wirings 220 that face each other. Then, electronic component 178 is mounted inside cavity 223 such that electrodes 182 at the lower surface of electronic component 178 come into contact with bumps 234 formed on wirings 220. Next, electronic component 178 mounted inside cavity 223 is pressed downward from above by pressing plate 122 via rubber plate 124. At this time, thermosetting resin 230 is heated and cured. Then, after thermosetting resin 231 is discharged between the side surface of electronic component 178 and cavity 223, thermosetting resin 231 is heated and cured. In this way, electronic component 178 is mounted inside cavity 223 of resin layered body 222 and fixed by thermosetting resins 230 and 231. Note that the electrode of two electrodes 182 of electronic component 178 that comes into contact with bump 234 formed on wiring 220a is referred to as electrode 182a, and the electrode of two electrodes 182 that comes into contact with bump 234 formed on wiring 220b is referred to as electrode 182b.

Subsequently, in second shaping unit 23, resin layered body 226 is formed on resin layered body 222 and electronic component 178, as shown in Fig. 21. Resin layered body 226 covers resin layered body 222 and electronic component 178 except for electrode 182b at the upper surface of electronic component 178, and opening 228 through which electrode 182b at the upper surface of electronic component 178 is exposed is formed in resin layered body 226. Among wall surfaces defining opening 228, the wall surface on a side from electrode 182b toward electrode 182a is formed in inclined surface 227.

Subsequently, in first shaping unit 22, two wirings 232a and 232b are formed on an upper surface of resin layered body 226, as shown in Fig. 22. Wiring 232a is formed at the same position as wiring 196a of circuit board 210, and a length of wiring 232a is substantially the same as a length of wiring 196a. In addition, wiring 232b is formed so as to approach wiring 232a from opening 228 of resin layered body 226 via inclined surface 227, and wiring 232b is connected to electrode 182b at the upper surface of electronic component 178 exposed through opening 228 of resin layered body 226. Wiring 232 is formed by the same method as wiring 162.

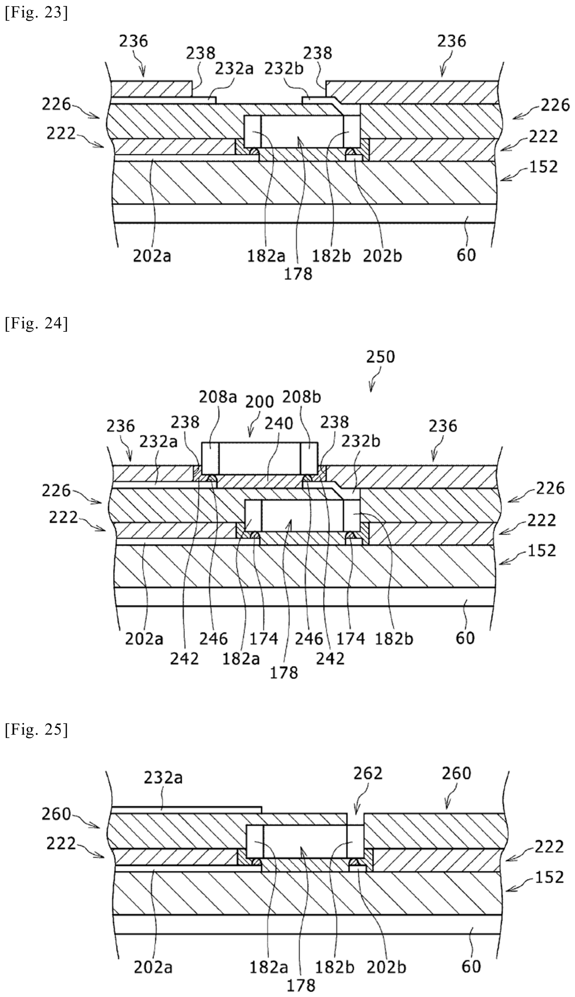

Subsequently, in second shaping unit 23, resin layered body 236 is formed on resin layered body 226, as shown in Fig. 23. Resin layered body 236 is formed on resin layered body 226 such that end portions of two wirings 232 that face each other are exposed. Meanwhile, a step portion between resin layered body 226 and resin layered body 236 functions as cavity 238. Resin layered body 236 is formed by the same method as resin layered body 152.

Then, as shown in Fig. 24, electronic component 200 is mounted inside cavity 238 of resin layered body 236 and fixed by thermosetting resins 240 and 242. That is, when resin layered body 236 is formed, conductive paste is discharged onto the end portions of two wirings 232 that face each other, and cured by heating of heater 66, whereby bumps 246 are formed. Next, thermosetting resin 240 is discharged between the end portions of two wirings 232 that face each other. Then, electronic component 200 is mounted inside cavity 238 such that electrodes 208 at the lower surface of electronic component 200 come into contact with bumps 246 formed on wirings 232. Next, electronic component 200 mounted inside cavity 238 is pressed downward from above by pressing plate 122 via rubber plate 124. At this time, thermosetting resin 240 is heated and cured. Then, after thermosetting resin 242 is discharged between the side surface of electronic component 200 and cavity 238, thermosetting resin 242 is heated and cured. In this way, electronic component 200 is mounted inside cavity 238 of resin layered body 236 and fixed by thermosetting resins 240 and 242. Note that the electrode of two electrodes 208 of electronic component 200 that comes into contact with bump 246 formed on wiring 232a is referred to as electrode 208a, and the electrode of two electrodes 208 that comes into contact with bump 246 formed on wiring 232b is referred to as electrode 208b.

Consequently, circuit board 250 in which two electronic components 178 and 200 are stacked is formed. In circuit board 250, wiring 232b is led out from electrode 182b at the upper surface of lower-layer electronic component 178, and wiring 232b is connected to electrode 208b at the lower surface of upper-layer electronic component 200. Therefore, in circuit board 250, the wiring path connecting electrode 182b of electronic component 178 to electrode 208b of electronic component 200 is significantly shorter than the wiring path connecting electrode 182b of electronic component 178 to electrode 208b of electronic component 200 in circuit board 210. As a result, it is possible to reduce a circuit area and improve circuit characteristics by reducing wiring resistance.

In addition, in circuit board 250, electrode 182b at the lower surface of electronic component 178 is connected to wiring 220b via bump 234, but wiring 220b is not connected to any component or wiring. In this way, although wiring 220b is not used as a member for electrical connection, by disposing wiring 220b below electrode 182b, it is possible to keep electronic component 178 horizontal inside circuit board 250.

Further, in circuit board 250, electrode 182b of electronic component 178 and electrode 208b of electronic component 200 are connected by wiring 232b, but electrode 182b of electronic component 178 and electrode 208b of electronic component 200 may also be connected by a bump. Specifically, as shown in Fig. 25, in second shaping unit 23, resin layered body 260 is formed on electronic component 178 and resin layered body 222. Resin layered body 260 has substantially the same shape as resin layered body 226 of circuit board 250, and opening 262 through which electrode 182b at the upper surface of electronic component 178 is exposed is formed in resin layered body 260, in the same manner as resin layered body 226. It should be noted that unlike opening 228 of resin layered body 226, no inclined surface is formed in opening 262 of resin layered body 260. Additionally, resin layered body 260 is formed by the same method as resin layered body 152. Subsequently, when resin layered body 226 is formed, wiring 232a is formed on resin layered body 260 in first shaping unit 22. It should be noted that only wiring 232a is formed, and wiring 232b is not formed, unlike circuit board 250.

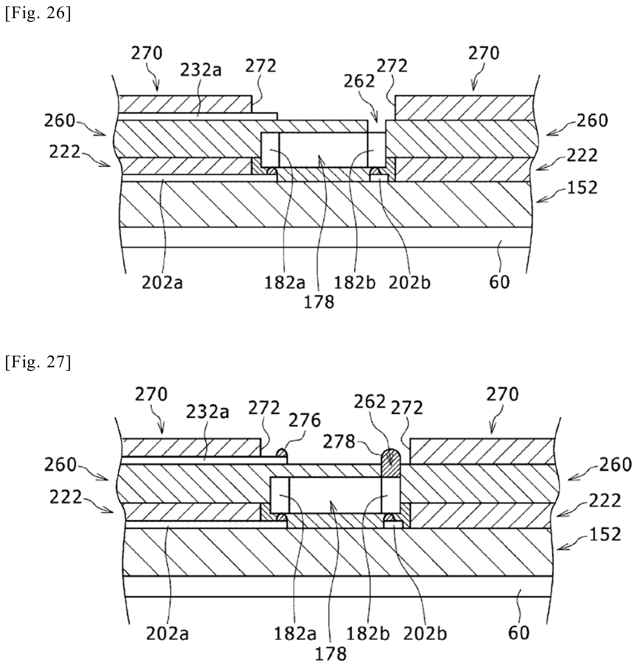

Subsequently, in second shaping unit 23, resin layered body 270 is formed on resin layered body 260, as shown in Fig. 26. Resin layered body 270 is formed on resin layered body 260 such that the end portion of wiring 232a and opening 262 of resin layered body 260 are exposed. Meanwhile, a step portion between resin layered body 260 and resin layered body 270 functions as cavity 272. Resin layered body 270 is formed by the same method as resin layered body 152.

Subsequently, in third shaping unit 24, conductive paste is discharged onto the end portion of wiring 232a and cured by heating of heater 66, whereby bump 276 is formed, as shown in Fig. 27. In addition, conductive paste is discharged into opening 262 of resin layered body 260 and cured by heating of heater 66, whereby bump 278 is formed. The conductive paste is discharged into opening 262 of resin layered body 260 such that a height dimension of bump 278 is substantially the same as a height dimension of bump 276.

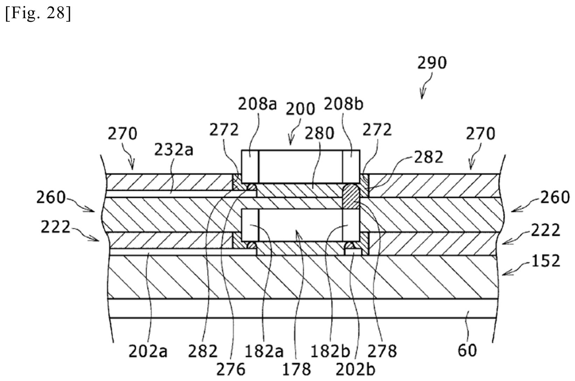

Then, as shown in Fig. 28, electronic component 200 is mounted inside cavity 272 of resin layered body 270 and fixed by thermosetting resins 280 and 282. That is, when bumps 276 and 278 are formed, thermosetting resin 280 is discharged between the end portion of wiring 232a and bump 278. Then, electronic component 200 is mounted inside cavity 272 such that electrode 208a at the lower surface of electronic component 200 comes into contact with bump 276 and electrode 208b at the lower surface of electronic component 200 comes into contact with bump 278. Next, electronic component 200 mounted inside cavity 272 is pressed downward from above by pressing plate 122 via rubber plate 124. At this time, thermosetting resin 280 is heated and cured. Then, after thermosetting resin 282 is discharged between the side surface of electronic component 200 and cavity 272, thermosetting resin 282 is heated and cured. In this way, electronic component 200 is mounted inside cavity 272 of resin layered body 270 and fixed by thermosetting resins 280 and 282.

Consequently, circuit board 290 in which two electronic components 178 and 200 are stacked is formed. In circuit board 290, electrode 182b at the upper surface of lower-layer electronic component 178 and electrode 208b at the lower surface of upper-layer electronic component 200 are connected by bump 278. Therefore, in circuit board 290, the wiring path connecting electrode 182b of electronic component 178 to electrode 208b of electronic component 200 is significantly shorter than the wiring path connecting electrode 182b of electronic component 178 to electrode 208b of electronic component 200 in circuit board 210. Furthermore, in circuit board 290, the wiring path connecting electrode 182b of electronic component 178 to electrode 208b of electronic component 200 is significantly shorter than the wiring path connecting electrode 182b of electronic component 178 to electrode 208b of electronic component 200 in circuit board 250. As a result, it is possible to further reduce a circuit area and further improve circuit characteristics by further reducing wiring resistance.

In addition, controller 140 of control device 28 includes first component placing section 300, resin layer forming section 302, second component placing section 304, wiring forming section 306, and discharge section 308, as shown in Fig. 2. First component placing section 300 is a functional section that places electronic component 178 such that electrode 182 at the lower surface of electronic component 178 is electrically connected to wiring 220 in circuit boards 250 and 290. Resin layer forming section 302 is a functional section that forms resin layered bodies 226 and 260 including openings 228 and 262 through which electrode 182 at the upper surface of electronic component 178 is exposed in circuit boards 250 and 290. Second component placing section 304 is a functional section that places electronic component 200 such that electrode 208 at the lower surface of electronic component 200 is electrically connected to electrode 182 at the upper surface of electronic component 178 exposed from openings 228 and 262 in circuit boards 250 and 290. Wiring forming section 306 is a functional section that forms wiring 232 that electrically connects electrode 182 at the upper surface of electronic component 178 and electrode 208 at the lower surface of electronic component 200 in circuit board 250. Discharge section 308 is a functional section that discharges conductive paste into opening 262 of resin layered body 260 in circuit board 290.

In the above-mentioned example, circuit forming apparatus 10 is an example of a circuit forming apparatus. Second shaping unit 23 is an example of a resin layer forming device. Mounting unit 27 is an example of a placing device. Control device 28 is an example of a control device. Electronic component 178 is an example of a first component. Electrode 182 is an example of a conductive portion. Electronic component 200 is an example of a second component. Electrode 208 is an example of a conductive portion. Wiring 220 is an example of wiring. Resin layered bodies 226 and 260 are examples of a resin layer. Openings 228 and 262 are examples of an opening. Wiring 232 is an example of wiring. Additionally, the step and the process executed by first component placing section 300 are examples of a first component placing step and a first component placing process. The step and the process executed by resin layer forming section 302 are examples of a resin layer forming step and a resin layer forming process. The step and the process executed by second component placing section 304 are examples of a second component placing step and a second component placing process. A step executed by wiring forming section 306 is an example of a wiring forming step. A step executed by discharge section 308 is an example of a discharge step.

It should be noted that the present invention is not limited to the above-mentioned examples, and various aspects can be implemented with various modifications and improvements made based on the knowledge of those skilled in the art. For example, in the above-mentioned examples, electronic components 178 and 200 have been employed as components that conduct between the upper surface and the lower surface, but a component such as a terminal block may be employed. The terminal block functions as, for example, a contact point, a pad, a heat dissipation plate, or the like of the circuit board, and includes a metal mass exposed on an upper surface and a lower surface.

Further, in the above-mentioned examples, electronic components 178 and 200 are disposed in two layers in circuit boards 250 and 290, but multiple electronic components may be disposed in three or more stacked layers.

### Reference Signs List

10: Circuit forming apparatus, 23: Second shaping unit (forming device), 27: Mounting unit (mounting device), 28: Control device, 178: Electronic component (first component), 182: Electrode (conductive portion), 200: Electronic component, 208: Electrode (conductive portion), 220: Wiring, 226: Resin layered body (resin layer), 228: Opening, 232: Wiring, 260: Resin layered body, 262: Opening, 300: First component placing section (first component placing step) (first component placing process), 302: Resin layer forming section (resin layer forming step) (resin layer forming process), 304: Second component placing section (second component placing step) (second component placing process), 306: Wiring forming section (wiring forming step), 308: Discharge section (discharge step)

## Claims

1. A circuit forming method comprising:
a first component placing step of placing, on wiring, a first component including a conductive portion configured to conduct between an upper surface and a lower surface such that the conductive portion at the lower surface of the first component is electrically connected to the wiring;
a resin layer forming step of forming, on the first component and the wiring, a resin layer including an opening through which the conductive portion at the upper surface of the first component is exposed; and
a second component placing step of placing, on the first component, a second component including a conductive portion at least at a lower surface such that the conductive portion at the lower surface of the second component is electrically connected to the conductive portion at the upper surface of the first component exposed through the opening.

2. The circuit forming method according to Claim 1, further comprising:
a wiring forming step of forming wiring that is connected to the conductive portion at the upper surface of the first component exposed through the opening, using a metal-containing liquid containing metal fine particles after the resin layer is formed in the resin layer forming step, wherein
in the second component placing step,
the second component is placed on the first component such that the conductive portion at the lower surface of the second component is electrically connected to the wiring formed in the wiring forming step.

3. The circuit forming method according to Claim 1, further comprising:
a discharge step of discharging a conductive fluid to the conductive portion at the upper surface of the first component exposed through the opening after the resin layer is formed in the resin layer forming step, wherein
in the second component placing step,
the second component is placed on the first component such that the conductive portion at the lower surface of the second component comes into contact with the conductive fluid discharged in the discharge step.

4. The circuit forming method according to any one of Claims 1 to 3, wherein in the resin layer forming step, the resin layer is formed by discharging a curable resin onto the first component and the wiring.

5. A circuit forming apparatus comprising:
a placing device configured to place a component at a certain position;
a resin layer forming device configured to form a resin layer using a curable resin; and
a control device, wherein
the control device is configured to execute:
a first component placing process of placing, by the placing device, on wiring, a first component including a conductive portion configured to conduct between an upper surface and a lower surface such that the conductive portion at the lower surface of the first component is electrically connected to the wiring;
a resin layer forming process of forming, by the resin layer forming device, on the first component and the wiring, a resin layer including an opening through which the conductive portion at the upper surface of the first component is exposed; and
a second component placing process of placing, by the placing device, on the first component, a second component including a conductive portion at least at a lower surface such that the conductive portion at the lower surface of the second component is electrically connected to the conductive portion at the upper surface of the first component exposed through the opening.
